# EUROPÄISCHE PATENTSCHRIFT

(11) **EP 2 885 800 B1**
(45) Veröffentlichungstag und Bekanntmachung des Hinweises auf die Patenterteilung: **31.05.2017**
(21) Anmeldenummer: 12751009.7
(22) Anmeldetag: 17.08.2012
(51) Int. Cl.: H01H 9/10, H01H 85/02, H01H 9/16

(54) **BAUGRUPPE FÜR EINE SCHALTERSICHERUNGSANORDNUNG MIT MESSVORRICHTUNG SOWIE SICHERUNGSHALTER FÜR EINE BAUGRUPPE ODER EINE SCHALTERSICHERUNGSANORDNUNG**
SUBASSEMBLY FOR A SWITCH FUSE ARRANGEMENT HAVING MEASURING DEVICE, AND FUSE HOLDER FOR A SUBASSEMBLY OR A SWITCH FUSE ARRANGEMENT
GROUPE DE CONSTRUCTION POUR UN ENSEMBLE DE FUSIBLES DE COMMUTATEURS AVEC DISPOSITIF DE MESURE ET PORTE-FUSIBLE POUR UN GROUPE DE CONSTRUCTION OU UN ENSEMBLE DE FUSIBLES DE COMMUTATEURS

(43) Veröffentlichungstag der Anmeldung: 24.06.2015
(73) Patentinhaber: Klaus Bruchmann GmbH, 4616 Weißkirchen an der Traun (AT)
(72) Erfinder: BRUCHMANN, Klaus, 96450 Coburg (DE)
(74) Vertreter: Appelt, Christian W.
(86) Internationale Anmeldenummer: PCT/EP2012/003516
(87) Internationale Veröffentlichungsnummer: WO 2014/026702

(56) Entgegenhaltungen:
- EP-A1- 0 530 563
- WO-A1-01/39233
- DE-A1- 4 112 169
- DE-A1- 4 332 305

## Beschreibung

Die vorliegende Erfindung bezieht sich auf eine Baugruppe für eine Schaltersicherungsanordnung, insbesondere für eine Schaltersicherungsanordnung für Sammelschienensysteme oder für Einbaugeräte. Bevorzugt werden 3-polige Schaltersicherungsanordnungen oder Einbaugeräte mit drei Schaltersicherungseinheiten verwendet, es ist aber auch möglich, 2-polige oder mehrpolige Schaltersicherungsanordnungen oder Einbaugeräte vorzusehen. In Ausnahmefällen ist auch eine 1-polige Schaltersicherungsanordnung oder ein 1-poliges Einbaugerät möglich. Solche Vorrichtungen werden insbesondere zur Absicherung von Drehstromkreisen eingesetzt, wobei bei einem solchen Einsatzgebiet in der Regel 3-polige Einheiten notwendig sind.

Eine mehrpolige Schaltersicherungsanordnung für Sammelschienen ist beispielsweise aus der DE 199 37 017 C1 bekannt.

Ferner ist aus der DE 41 12 169 A1 eine Schaltersicherungsanordnung bekannt, die eine Messvorrichtung zur Ermittlung elektrischer Betriebswerte umfasst und wobei die Messvorrichtung eine Messelektronik und eine Anzeigevorrichtung umfasst. Aus der WO 01/39233 A1 ist eine weitere Schaltersicherungsanordnung bekannt, die so ausgebildet ist, dass sie einen Sicherungseinsatz aufnehmen kann.

Es ist eine Aufgabe der vorliegenden Erfindung, eine Baugruppe für eine Schaltersicherungsanordnung, insbesondere für eine mehrpolige Schaltersicherungsanordnung oder für ein Einbaugerät, sowie Sicherungshalter für eine Baugruppe oder für Schaltersicherungsanordnungen oder Einbaugeräte zur Verfügung zu stellen, die eine bessere und/oder komfortablere Benutzung oder Bedienung durch den Nutzer ermöglichen. Diese Aufgabe wird durch eine Baugruppe gemäß Anspruch 1 und einen Sicherungshalter gemäß Anspruch 12 gelöst. Die Ansprüche 2 bis 11 betreffen besonders vorteilhafte Ausführungsformen der erfindungsgemäßen Baugruppe, die Ansprüche 13 bis 15 betreffen besonders vorteilhafte Ausführungsformen des erfindungsgemäßen Sicherungshalters.

Erfindungsgemäß umfasst die Baugruppe eine Messvorrichtung zur Messung elektrischer Betriebswerte, wobei die Messvorrichtung eine Messelektronik und mindestens eine Anzeigevorrichtung zur Anzeige mindestens eines der von der Messvorrichtung gemessenen elektrischen Betriebswerte aufweist. Ferner umfasst die erfindungsgemäße Baugruppe mindestens eine Spulenvorrichtung, die so ausgelegt ist, dass sie mittels Induktion Energiefür die Messvorrichtung, insbesondere für die Messelektronik und/oder die Anzeigevorrichtung, zur Verfügung stellen kann, insbesondere zumindest zeitweise die gesamte Energieversorgung für die Messelektronik und/oder die Anzeigevorrichtung zur Verfügung stellen kann.

Unter den elektrischen Betriebswerten sind im Sinne dieser Erfindung elektrische Werte zu verstehen, die den Betrieb der Baugruppe oder einer Schaltersicherungsanordnung oder Untereinheiten der Schaltersicherungsanordnung, insbesondere einzelner Schaltersicherungseinheiten betreffen. Insbesondere umfassen solche elektrischen Betriebswerte Stromwerte, Spannungswerte und/oder Leistungswerte. Elektrische Betriebswerte können Werte betreffen, die die Baugruppe oder eine Schaltersicherungsanordnung als Ganzes betreffen, bevorzugt betreffen die elektrischen Betriebswerte jedoch Werte einzelner Einheiten oder Phasen des Systems und/oder insbesondere einzelner Sicherungseinsätze.

Die mindestens eine Spulenvorrichtung ist erfindungsgemäß so ausgelegt, dass sie mittels Induktion Energie für die Messvorrichtung, insbesondere für die Messelektronik und/oder die Anzeigevorrichtung, zur Verfügung stellen kann, insbesondere wenn die Baugruppe oder eine Schaltersicherungsanordnung in Betrieb ist, insbesondere wenn sie bspw. an ein Sammelschienensystem angeschlossen ist, wenn es sich um eine Schaltersicherungsanordnung für ein Sammelschienensystem handelt, oder an eine andere Stromleitung angeschlossen ist, beispielsweise durch Verdrahtungsleitungen.

Der Strom, der durch einzelne Elemente der Baugruppe oder einer Schaltersicherungsanordnung, insbesondere durch einzelne Sicherungseinsätze, fließt, induziert mittels der Spulenvorrichtung einen Strom, der der Messvorrichtung direkt oder indirekt zur Verfügung gestellt werden kann, so dass die Messvorrichtung und/oder die Anzeigevorrichtung, zumindest teilweise oder zumindest zeitweise, keine zusätzliche Energieversorgung oder eine geringere Zuführung von Energie benötigt.

Die erfindungsgemäße Baugruppe hat den Vorteil, dass für den Nutzer elektrische Betriebswerte der Baugruppe oder einzelner Phasen der Baugruppe oder einer Schaltersicherungsanordnung direkt sichtbar sind, so dass für den Nutzer der Betriebszustand sofort erkennbar ist. Damit werden dem Nutzer zum einen nützliche Informationen zur Verfügung gestellt, zum anderen insbesondere mögliche Fehlbedienungen vermieden.

Ein weiterer wichtiger Vorteil der erfindungsgemäßen Baugruppe ist, dass sie eine Spulenvorrichtung umfasst, die so ausgelegt ist, dass sie Energie für die Messvorrichtung und/oder Anzeigevorrichtung zur Verfügung stellen kann, so dass es auch möglich ist, die Messvorrichtung und die Anzeigevorrichtung zumindest zeitweise ohne eine zusätzliche Energieversorgung, sei es ein elektrischer Anschluss oder sei es eine Batterie oder ein Akkumulator, zu betreiben.

Bei einer Baugruppe im Sinne dieser Erfindung handelt es sich insbesondere um eine Untergruppe oder einzelne Bauteile einer Schaltersicherungsanordnung, insbesondere einer Schaltersicherungsanordnung für Sammelschienensysteme, oder um Bauteile oder eine Untergruppe eines Einbaugerätes. Eine bevorzugte Ausführungsform einer Baugruppe kann durch die gesamte Schaltersicherungsanordnung, insbesondere die Schaltersicherungsanordnung für Sammelschienensysteme, oder das Einbaugerät selbst realisiert werden. Gemäß einer anderen bevorzugten Ausführungsform handelt es sich bei der Baugruppe um einen Sammelschienenadapter, der auf ein Sammelschienensystem aufgesetzt werden kann, und an den wiederum Einbaugeräte, insbesondere Reiheneinbaugeräte, befestigt werden können.

Bevorzugt umfasst die Spulenvorrichtung einen Spulenkörper und mindestens eine Spulenwicklung, wobei bei einer besonders bevorzugten Ausführungsform die Spulenvorrichtung mindestens zwei Spulenwicklungen umfasst. Mindestens eine erste Spulenwicklung kann so ausgelegt sein, dass sie die Energieversorgung für die Messvorrichtung und/oder die Anzeigevorrichtung zur Verfügung stellt, wobei bevorzugt mindestens eine zweite Spulenvorrichtung so mit der Messvorrichtung direkt oder indirekt verbunden sein kann, dass mittels der mindestens einen zweiten Spulenwicklung und der Messvorrichtung elektrische Betriebswerte der Schaltersicherungsanordnung ermittelt werden können. Die Spulenvorrichtung kann daher zum einen so ausgelegt sein, dass sie lediglich die Energieversorgung für die Messvorrichtung und/oder die Anzeigevorrichtung zur Verfügung stellt, bevorzugt kann sie jedoch auch so ausgelegt sein, dass sie zusätzlich der Messung der elektrischen Betriebswerte dient, so dass auf einfache und effektive Weise eine duale Verwendung ermöglicht wird.

Bei einer bevorzugten Ausfiihrungsform ist die Spulenvorrichtung äußerlich ein Isolierkörper, wobei ferner bevorzugt die Spulenwicklungsausgänge vom Hauptstrompfad galvanisch getrennt sind. Dies hat den Vorteil, dass die Spulenvorrichtung von dem eigentlichen Stromkreis sicher getrennt ist.

Bevorzugt ist die Messvorrichtung so ausgebildet, dass elektrische Betriebswerte für einzelne Phasen, insbesondere einer Schaltersicherungsanordnung, getrennt ermittelt werden können. Dies hat den Vorteil, dass die elektrischen Betriebswerte genauer, nämlich für jede Phase, angezeigt werden, was dem Nutzer bessere und zuverlässigere Informationen über das Gesamtsystem zur Verfügung stellt.

Bevorzugt ist bei einer besonderen Ausführungsform der Baugruppe vorgesehen, dass die Messvorrichtung für jede Phase eine eigene Messelektronik und/oder für jede Phase mindestens eine Spulenvorrichtung umfasst.

Bei einer Ausführungsform der erfindungsgemäßen Baugruppe können die mindestens eine Messelektronik und/oder die mindestens eine Anzeigevorrichtung und/oder mindestens eine Spulenvorrichtung in oder an dem Gehäuse der Baugruppe, beispielsweise dem Gehäuse einer Schaltersicherungsanordnung, vorgesehen sein. Dies hat den Vorteil, dass diese Elemente immer mit der Baugruppe oder einer Schaltersicherungsanordnung verbunden sind, auch besteht dadurch die Möglichkeit, sämtliche Elemente möglichst platzsparend und in einer für die Herstellung kostengünstigen Weise anzubringen und/oder die Anzeigevorrichtung so anzuordnen, dass sie für den Nutzer besonders gut ersichtlich ist. Auch hat eine solche Ausführungsform den Vorteil, dass eine einzelne Anzeigevorrichtung für alle Phasen vorgesehen sein kann.

Bei einer anderen Baugruppe umfasst diese einen Sicherungshalter für jede Phase und jeden Sicherungseinsatz, wobei bevorzugt zumindest ein Sicherungshalter, besonders bevorzugt jeder Sicherungshalter eine Messelektronik, mindestens eine Anzeigevorrichtung und mindestens eine Spulenvorrichtung umfasst. Eine solche Vorrichtung hat den Vorteil, dass für jede einzelne Phase und für jeden einzelnen Sicherungseinsatz eine unabhängige Messung stattfindet und die Werte für jede Phase separat angezeigt werden können, ferner können die Werte direkt in der Nähe des zughörigen Sicherungseinsatzes, nämlich an dem Sicherungshalter, angezeigt werden. Ferner hat diese Ausgestaltung den Vorteil, dass in dem Falle, in dem eine Messelektronik oder eine Anzeigevorrichtung oder eine Spulenvorrichtung beschädigt ist oder nicht mehr funktioniert, lediglich ein Sicherungshalter ausgetauscht werden braucht.

Bei einer weiteren Ausführungsform ist mindestens eine Anzeigevorrichtung von der Baugruppe und/oder von einem Sicherungshalter abnehmbar ausgestaltet. Eine solche abnehmbare Anzeigevorrichtung kann beispielsweise mit der Baugruppe, insbesondere mit einem Gehäuse der Baugruppe, oder mit einem Sicherungshalter mittels einer Steckervorrichtung verbunden sein. Bei einer anderen bevorzugten Ausführungsform ist eine drahtlose Verbindung vorgesehen. Insbesondere die drahtlose Verbindung hat den Vorteil, dass die Anzeigevorrichtung auch von der Baugruppe, beispielsweise einer Schaltersicherungsanordnung, entfernt angeordnet und daher in einer besonders bevorzugten Position für den Nutzer angeordnet werden kann.

Bei einer weiteren Ausführungsform umfasst die Baugruppe auch einen Akkumulator und/oder eine Batterie und/oder eine Solarzelle, wobei diese zusätzlichen Energieversorger so ausgelegt sind, dass sie der Messvorrichtung Energie zuführten können. Dies kann von Vorteil sein, um der Messvorrichtung zusätzlich zu der mittels der Spulenvorrichtung durch Induktion erzeugten Energie weitere Energie zuzuführen, womit beispielsweise die elektrischen Betriebswerte exakter bestimmt werden können oder aber elektrische Betriebswerte bereits bestimmt werden können, selbst wenn der Strom bzw. die Energie, die durch die Baugruppe oder eine Schaltersicherungseinheit oder durch eine Phase fließt, relativ gering ist. Ein weiterer Vorteil einer solchen zusätzlichen Energieversorgungseinheit ist es, dass die Messvorrichtung und/oder die Anzeigevorrichtung auch dann funktionieren, wenn die Baugruppe oder eine Schaltersicherungsanordnung oder das Sammelschienensystem nicht in Betrieb sind bzw. kein Strom durch die Baugruppe oder Teile der Baugruppe fließt.

Bei einer weiteren bevorzugten Ausführungsform umfasst die Baugruppe auch einen N-Leiter, der an die Messvorrichtung angeschlossen ist. Damit können die elektrischen Betriebsergebnisse genauer ermittelt werden und/oder zusätzliche elektrische Betriebswerte, wie beispielsweise die Leistung, ermittelt werden. Dies hat den Vorteil, dass weitere Rückschlüsse auf das betriebene Systems geschlossen werden können.

Die Erfindung betrifft ferner einen Sicherungshalter für eine Baugruppe, beispielsweise eine Schaltersicherungsanordnung, der so ausgebildet ist, dass er einen Sicherungseinsatz aufnehmen kann. Erfindungsgemäß umfasst der Sicherungshalter eine Messvorrichtung zur Messung elektrischer Betriebswerte, wobei die Messvorrichtung eine Messelektronik und mindestens eine Anzeigevorrichtung zur Anzeige mindestens eines der von der Messvorrichtung ermittelten elektrischen Betriebswerte aufweist. Der erfindungsgemäße Sicherungshalter umfasst mindestens eine Spulenvorrichtung, die so ausgelegt ist, dass sie mittels Induktion eine Energieversorgung für die Messelektronik und/oder die Anzeigevorrichtung zur Verfügung stellen kann.

Ein solcher Sicherungshalter hat den Vorteil, dass er in eine beliebige Baugruppe eingesetzt werden kann, auch in Baugruppen oder Schaltersicherungsanordnungen nach dem Stand der Technik, wobei die oben beschriebenen Vorteile erreicht werden.

Bei einer besonders bevorzugten Ausführungsform umfasst eine Baugruppe oder ein Sicherungshalter gemäß der vorliegenden Erfindung auch einen Taster, mit dem die Messvorrichtung ein- und/oder ausgeschaltet werden kann, bzw. für einen kurzen Zeitraum aktiviert werden kann. Dies hat den Vorteil, dass die Messvorrichtung nur dann aktiviert wird, wenn sie tatsächlich gebraucht oder für den Nutzer sinnvoll ist.

Als zusätzliche, optionale Möglichkeit für einen solchen Taster kann bei einer Ausführungsform auch vorgesehen sein, dass mittels das Tasters eine Umschaltung der Messvorrichtung oder der Funktion der Messvorrichtung vorgenommen werden kann. Beispielsweise kann mittels eines Tasters die Messvorrichtung von einer Messung des Stromwerts auf eine Messung des Leistungswerts umgeschaltet werden. Eine weitere Möglichkeit besteht darin, mittels des Tasters einen Minimalwert, einen Maximalwert oder einen Durchschnittswert der elektrischen Betriebswerte anzeigen zu lassen, beispielsweise auch über einen bestimmten festzulegenden Zeitraum.

Im Hinblick auf besonders vorteilhafte Ausgestaltung eines solchen Sicherungshalters oder einer Messvorrichtung oder einer Spulenvorrichtung, die in einer erfindungsgemäßen Baugruppe vorgesehen ist, wird zur Vermeidung von Wiederholungen auf die obigen Ausführungen verwiesen.

Diese und weitere Merkmale der vorliegenden Erfindung werden anhand der nachfolgenden Zeichnungen, die besonders vorteilhafte Ausführungsformen zeigen, noch deutlicher:
- Fig. 1: zeigt eine Ausführungsform einer erfindungsgemäßen Baugruppe;
- Fig. 2: zeigt eine Ausführungsform eines erfindungsgemäßen Sicherungshalters;
- Fig. 3: zeigt eine Teilansicht eines Gehäuses einer Ausführungsform einer erfindungsgemäßen Baugruppe;
- Fig. 4: zeigt schematisch ein Schaltbild einiger Elemente einer erfindungsgemäßen Baugruppe oder eines erfindungsgemäßen Sicherungshalters;
- Fig. 5: zeigt im Querschnitt eine Ausführungsform eines erfindungsgemäßen Sicherungshalters;
- Fig. 6: zeigt eine Teilquerschnittsansicht einer Ausführungsform einer erfindungsgemäßen Baugruppe;
- Fig. 7: zeigt eine Querschnittsansicht einer weiteren Ausführungsform eines erfindungsgemäßen Sicherungshalters;
- Fig. 8: zeigt schematisch ein Schaltbild einiger Elemente einer erfindungsgemäßen Baugruppe oder eines erfindungsgemäßen Sicherungshalters in einer weiteren Ausführungsform
- Fig. 9: zeigt eine weitere Ausführungsform einer erfindungsgemäßen Baugruppe; und
- Fig. 10: zeigt eine weitere Ausführungsform einer erfindungsgemäßen Baugruppe; und
- Fig. 11: zeigt einen schematischen Querschnitt durch die in Fig. 10 gezeigte Ausführungsform.

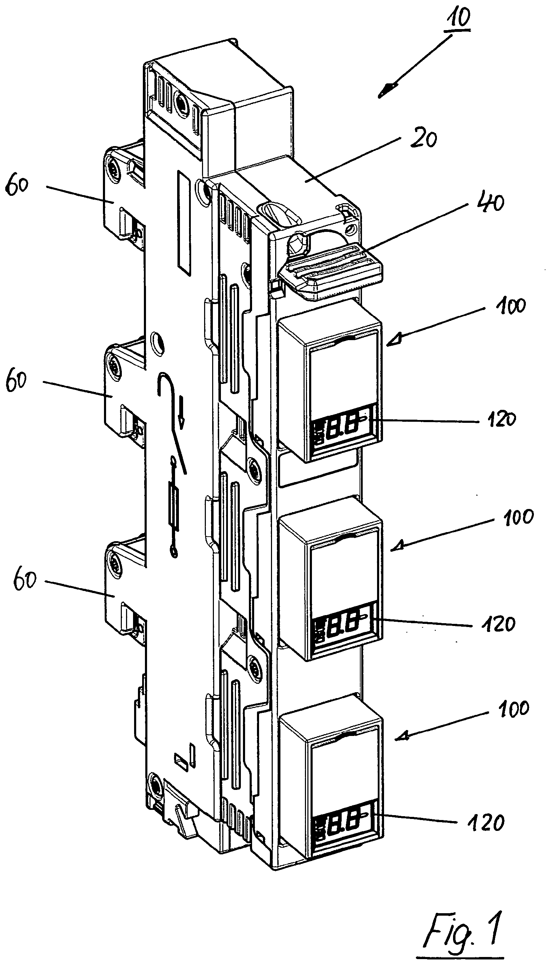

Fig. 1 zeigt eine perspektivische Ansicht einer ersten Ausführungsform einer erfindungsgemäßen Baugruppe, wobei es sich bei dieser Ausführungsform um eine Schaltersicherungsanordnung 10 handelt, die 3-polig ausgebildet ist und daher drei Schaltersicherungseinheiten umfasst, in die jeweils ein Sicherungshalter 100 eingesetzt ist. Bei dieser Schaltersicherungsanordnung 10 handelt es sich um eine Schaltersicherungsanordnung 10 für ein Sammelschienensystem. Die Schaltersicherungseinheiten sind in einem Gehäuse 20 der Schaltersicherungsanordnung 10 untergebracht.

Bei dieser Ausführungsform umfasst die Schaltersicherungsanordnung ein gemeinsames Gehäuse 20, wobei die einzelnen Schaltersicherungseinheiten durch Zwischenwände getrennt sind. Dies kann jedoch anders gelöst werden, beispielsweise durch voneinander getrennte Einzelgehäuse für Schaltersicherungseinheit, die beispielsweise lediglich miteinander verbunden sind.

Die Schaltersicherungsanordnung 10 umfasst Befestigungsvorrichtungen 60 zur Befestigung der Schaltersicherungseinheit an (nicht gezeigten) Sammelschienen eines Sammelschienensystems.

Bei der in Fig. 1 gezeigten Ausführungsform sind insgesamt drei Sicherungshalter 100 in die Sicherungseinheit 10 eingesetzt. Mittels eines Schalters 40 kann die Schaltersicherungseinheit eingeschaltet bzw. ausgeschaltet werden.

Jeder der Sicherungshalter 100 umfasst eine Anzeigevorrichtung 120 zur Anzeige von elektrischen Betriebswerten, insbesondere zur Anzeige der Spannung, des Stroms und/oder der Leistung der jeweiligen Phase der Schaltersicherungseinheit 10.

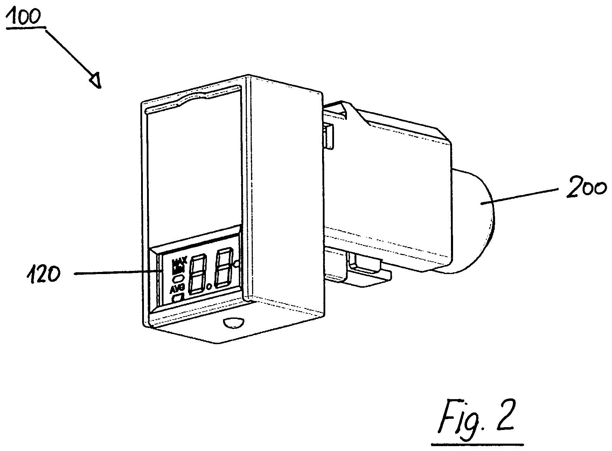

Fig. 2 zeigt eine perspektivische Ansicht einer Ausführungsform eines erfindungsgemäßen Sicherungshalters 100 mit einer Anzeige 120, wie er auch in der Schaltersicherungseinheit 10 verwendet werden kann, die in Fig. 1 gezeigt ist. In den Sicherungshalter 100 ist ein Sicherungseinsatz 200 eingesetzt.

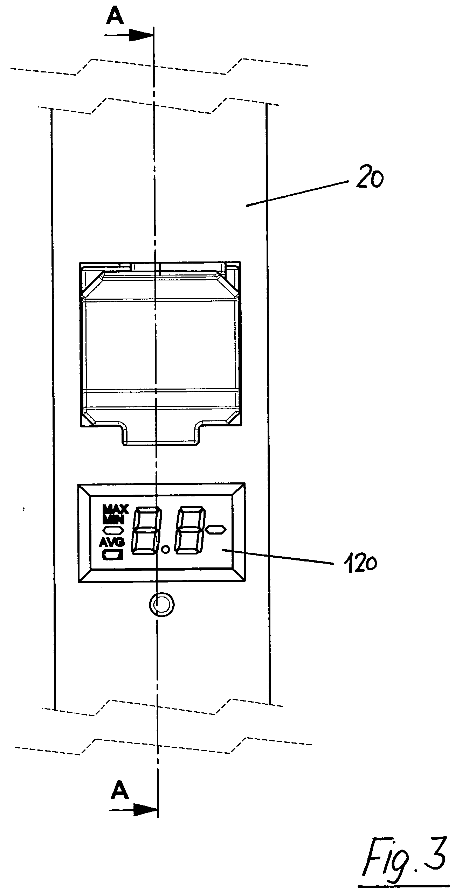

Fig. 3 zeigt eine Teilansicht einer anderen Ausführungsform einer erfindungsgemäßen Baugruppe, wobei es sich auch bei dieser Baugruppe um eine Schaltersicherungsanordnung 10 handelt. Im Gegensatz zu der in Figur 1 gezeigten Ausführungsform ist eine Anzeigevorrichtung 120 in dem Gehäuse 20 der Schaltersicherungsanordnung 10 vorgesehen. Bei dieser Ausführungsform umfasst das Gehäuse 20 insgesamt drei Anzeigevorrichtungen 120, jeweils eine Anzeigevorrichtung pro Phase, es ist jedoch auch möglich, dass eine gemeinsame Anzeigevorrichtung für alle Phasen vorgesehen ist.

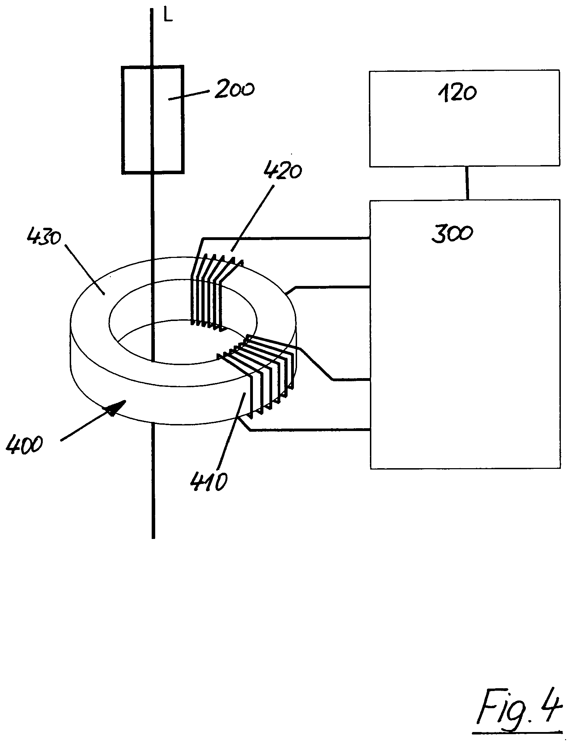

Fig. 4 zeigt schematisch ein Schaltbild, das wichtige Elemente einer Ausführungsform einer erfindungsgemäßen Baugruppe darstellt: Ein Sicherungseinsatz 200 wird in einer Baugruppe betrieben, die Linie L symbolisiert eine Leitung bzw. einen Strompfad. Wie in Fig. 4 ersichtlich, ist eine Spulenvorrichtung 400 vorgesehen, die einen Spulenkörper 430 und eine erste Spulenwicklung 410 sowie eine zweite Spulenwicklung 420 umfässt.

Durch den Wechselstrom, der durch die Leitung L und damit durch den Sicherungseinsatz 200 geleitet wird, wird in den Leitungen der ersten Spulenwicklung 410 und der zweiten Spulenwicklung 420 ein Strom induziert.

Die erste Spulenwicklung 410 ist, direkt oder indirekt, mit einer Messelektronik 300 verbunden und versorgt diese und die daran angeschlossene Anzeigevorrichtung 120 durch den induzierten Strom mit Energie.

Die zweite Spulenwicklung 420 ist ebenfalls, direkt oder indirekt, mit der Messelektronik 300 verbunden und dient der Ermittlung der elektrischen Betriebswerte.

Die Vorrichtung umfasst eine Anzeigevorrichtung 120, die ebenfalls mit der Messvorrichtung verbunden ist und die ermittelten elektrischen Betriebswerte anzeigen kann.

Die in Figur 4 dargestellten Elemente können sowohl in einem Gehäuse einer Baugruppe als auch in einem Sicherungshalter vorgesehen sein.

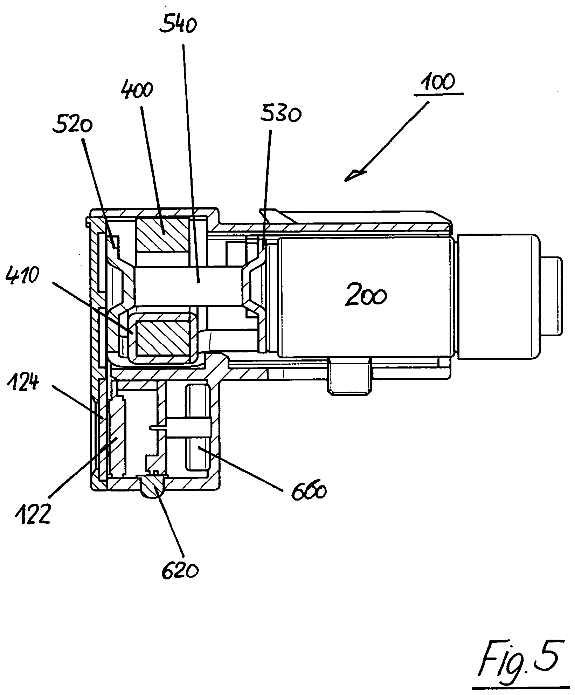

Figur 5 zeigt einen Querschnitt durch eine Ausführungsform eines erfindungsgemäßen Sicherungshalters 100, in den ein Sicherungseinsatz 200 eingesetzt ist. Der Sicherungseinsatz 200 kontaktiert einen unteren Kontakt 530 des Sicherungshalters 100, der wiederum über einen Shunt 540 mit einem oberen Kontakt 520 des Sicherungshalters 100 verbunden ist.

Wie gut in Figur 5 ersichtlich, umfasst der Sicherungshalter 100 eine Spulenvorrichtung 400 mit einem Spulenkörper 430 und einer ersten Spulenwicklung 410 (lediglich schematisch dargestellt) und einer zweiten Spulenwicklung (nicht gezeigt), wobei im Hinblick auf die Verbindung dieser Elemente auf Figur 4 und die zugehörige Erläuterung verwiesen wird.

Der in Figur 5 gezeigte Sicherungshalter umfasst ferner eine Anzeigevorrichtung 120, die einen Display 122 und eine davor angeordnete Schutzscheibe 124 umfasst.

Ferner umfasst die in Figur 5 gezeigte Ausführungsform des Sicherungshalters eine Batterie 660 zur zusätzlichen Versorgung der Messvorrichtung sowie einen Taster 620, mit dem die Messvorrichtung ein- und ausgeschaltet werden kann. Ferner umfasst der Taster 620 bei der in Figur 5 gezeigten Ausführungsform weitere Funktionsmerkmale, da die Messvorrichtung mittels des Tasters 620 wahlweise so geschaltet werden kann, dass sie entweder den Stromwert oder den Leistungswert misst. Optional ist es auch möglich, dass mittels des Tasters ein Minimalwert, ein Maximalwert oder ein Durchschnittswert der Messungen angezeigt werden kann. Sowohl Batterie 660 als auch Taster 620 sind lediglich optionale Elemente.

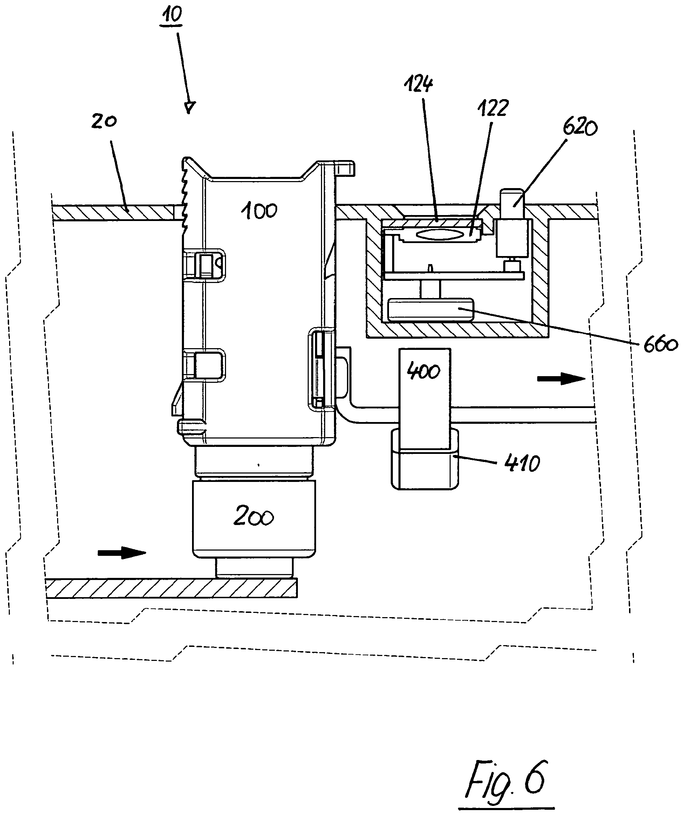

Fig. 6 zeigt einen Teilquerschnitt durch eine weitere Ausführungsform einer erfindungsgemäßen Baugruppe, wobei es sich auch hier um eine Schaltersicherungsanordnung 10 mit Sicherungshaltern 100 handelt, von denen nur ein Sicherungshalter gezeigt ist, in den ein Sicherungseinsatz 200 eingesetzt ist. Sowohl die Messvorrichtung als auch die Anzeigevorrichtung sind in dem Gehäuse 20 der Schaltersicherungsanordnung 10 angeordnet.

Analog zu den in Figur 5 gezeigten Ausführungsformen umfasst auch diese Schaltersicherungsanordnung 10 eine Anzeigevorrichtung 120 mit einem Display 122 und einer Schutzscheibe 124 sowie eine optionale Batterie 660 und einen Taster 620, allerdings sind diese Elemente in dem Gehäuse 20 der Schaltersicherungsanordnung 10 angeordnet und nicht in dem Sicherungshalter 100.

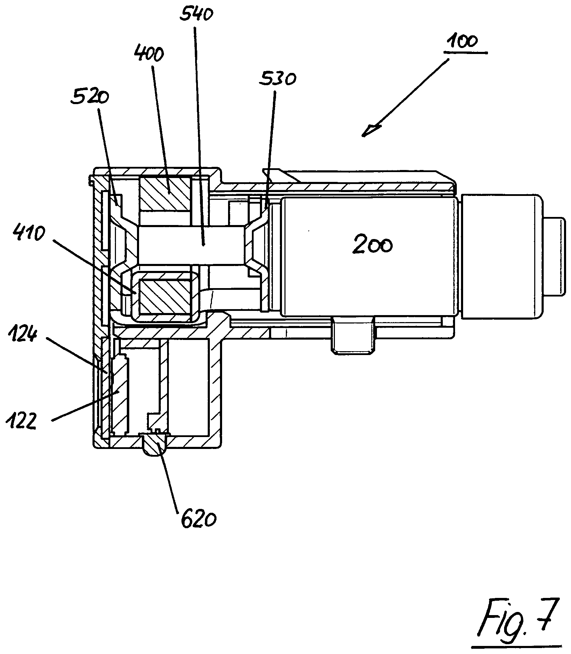

Figur 7 zeigt einen Querschnitt durch eine weitere Ausführungsform eines erfindungsgemäßen Sicherungshalters 100, der im Wesentlichen der in Figur 5 gezeigten Ausführungsform entspricht, so dass zur Vermeidung von Wiederholungen auf Figur 5 und die zugehörige Beschreibung verwiesen wird.

Im Gegensatz zu der in Figur 5 gezeigten Ausführungsform umfasst die Figur 7 gezeigte Ausführungsform des erfindungsgemäßen Sicherungshalters 100 jedoch keine Batterie oder eine sonstige zusätzliche Energieversorgung.

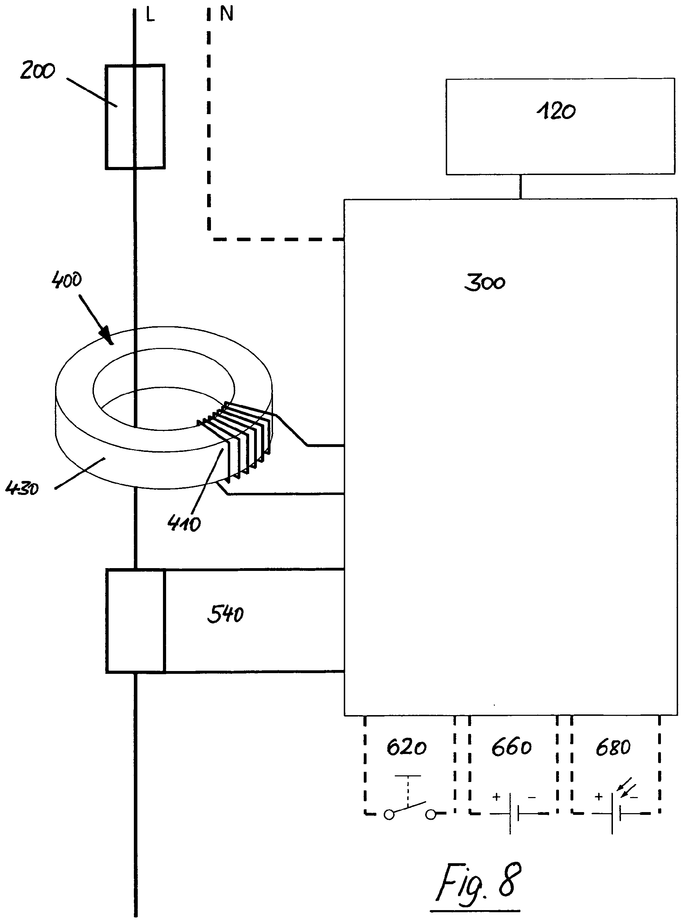

Figur 8 zeigt schematisch ein Schaltbild, das wichtige Elemente einer weiteren Ausführungsform einer erfindungsgemäßen Baugruppe oder eines erfindungsgemäßen Sicherungshalters darstellt.

Analog zu der in Fig. 4 gezeigten Ausführungsform umfasst die in Fig. 8 gezeigte Ausführungsform eine Spulenvorrichtung 400 mit einem Spulenkern 430 und einer ersten Spulenwicklung 410 zur Versorgung der Messelektronik 300 und/oder der Anzeigevorrichtung 120 mit Energie. Allerdings umfasst diese Ausführungsform keine zweite Spulenwicklung zur Unterstützung der Messung der elektrischen Betriebswerte. Diese Betriebswerte werden über einen Shunt 540 in Verbindung mit der Messelektronik 300 gemessen. Sowohl bei der in Figur 4 als auch bei der in Fig. 8 gezeigten Ausführungsform ist der Shunt 540 an einen Mikroprozessor angeschlossen, wobei der Mikroprozessor ein Teil der Messelektronik 300 ist. Optional ist es möglich, einen Verstärker vorzusehen, der bevorzugt ebenfalls Teil der Messelektronik 300 ist.

Zusätzlich umfasst diese Ausführungsform einen N-Leiter, der mit der Messelektronik 300 verbunden ist, so dass auch zusätzliche Betriebswerte, wie beispielsweise die Leistung, gemessen werden können.

Bei der in Figur 8 gezeigten Ausführungsform sind optionale Elemente vorgesehen, nämlich ein Taster 620, eine Batterie 660 und eine Solarzelle 680, wobei darauf hingewiesen werden muss, dass diese wohl gemeinsam als auch einzelnen vorgesehen sein können, jedoch nicht vorgesehen sein müssen.

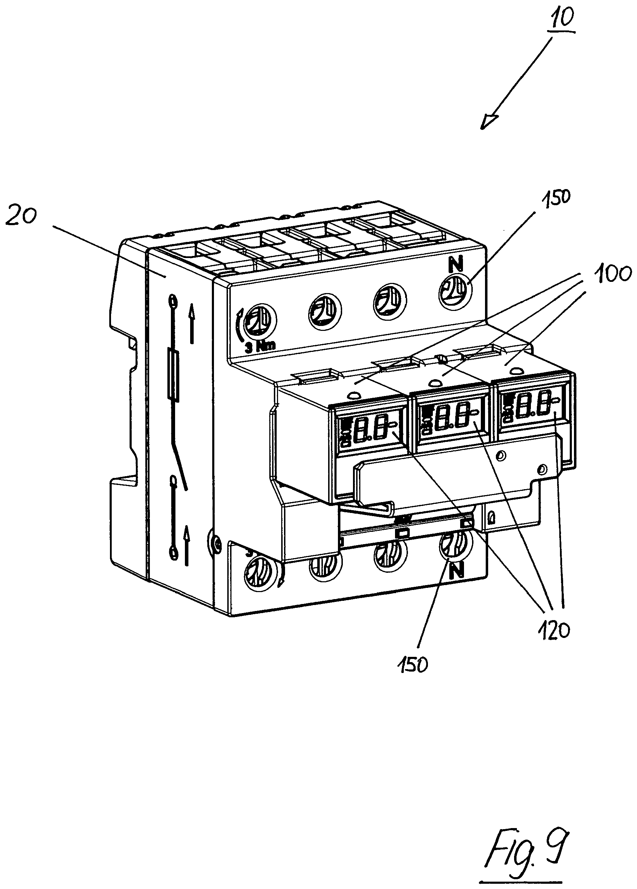

Fig. 9 zeigt eine weitere Ausführungsform einer erfindungsgemäßen Baugruppe, wobei es sich bei dieser Ausführungsform nicht um eine Schaltersicherungsanordnung für Sammelschienensysteme handelt, sondern um ein Einbaugerät.

Die funktionalen Elemente, insbesondere das Gehäuse und die Sicherungshalter, entsprechen im Wesentlichen der Schaltersicherungsanordnung, wie sie oben beschrieben worden ist. Gleiche oder ähnliche Elemente sind daher mit identischen Bezugszeichen versehen, und es wird, zur Vermeidung von Wiederholungen, im Hinblick auf die Merkmale und die Vorteile auf die oben beschriebene Ausführungsform verwiesen.

Die in Fig. 9 gezeigte Ausführungsform der Schaltersicherungseinheit 10 umfasst ein Gehäuse 20. Bei der Schaltersicherungsanordnung 10 handelt es sich um eine 3-polige Schaltersicherungsanordnung, in die insgesamt drei Sicherungshalter 100 eingesetzt werden können. Jeder der Sicherungshalter 100 umfasst eine Anzeige 120 zur Anzeige der ermittelten Betriebswerte.

Die in Fig. 9 gezeigte Ausführungsform der Schaltersicherungsanordnung umfasst auch Anschlüsse 150 für einen N-Leiter, im Hinblick auf die Vorteile eines solchen Anschlusses und eines N-Leiters wird auf die obige Beschreibung verwiesen.

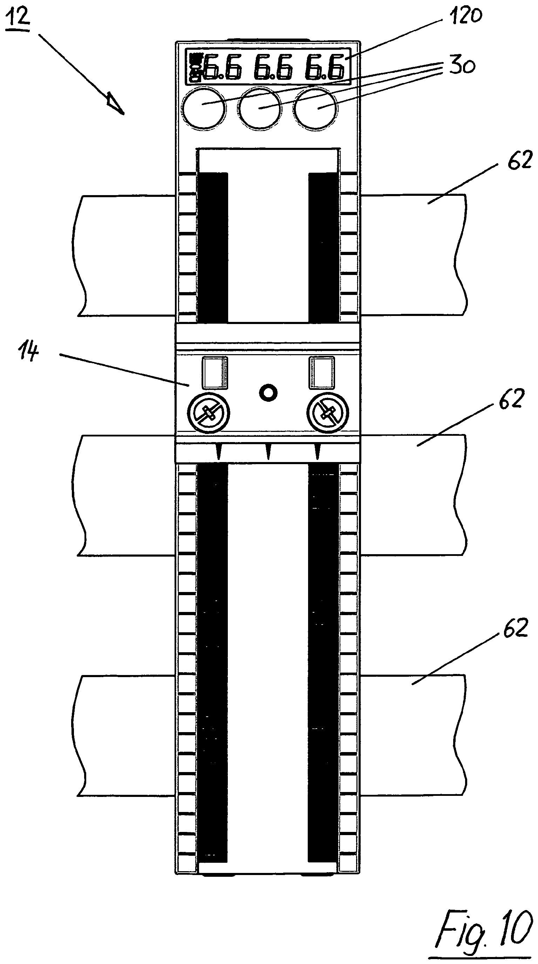

Fig. 10 zeigt eine weitere Ausführungsform einer erfindungsgemäßen Baugruppe, wobei es sich bei dieser Baugruppe um einen Sammelschienenadapter 12 handelt, der an Sammelschienen befestigt worden kann. Bei der hier gezeigten Ausführungsform handelt es sich um ein 3-poliges System mit drei Sammelschienen 62.

Der Sammelschienenadapter 12 umfasst eine Tragschiene 14, auf die zugehörige Einbaugeräte, insbesondere Reiheneinbaugeräte aufgesetzt werden können.

Der in Fig. 10 gezeigte Sammelschienenadapter 12 umfasst eine Anzeigevorrichtung 120 zur Anzeige der Betriebswerte, wobei bei dieser Ausführungsform sowohl Betriebswerte des Gesamtsystems als auch Betriebswerte für jede einzelne Phase, wie in Fig. 10 gezeigt, angezeigt werden können.

Der Sammelschienenadapter 12 umfasst insgesamt drei Öffnungen 30 für Anschlussleitungen des Systems.

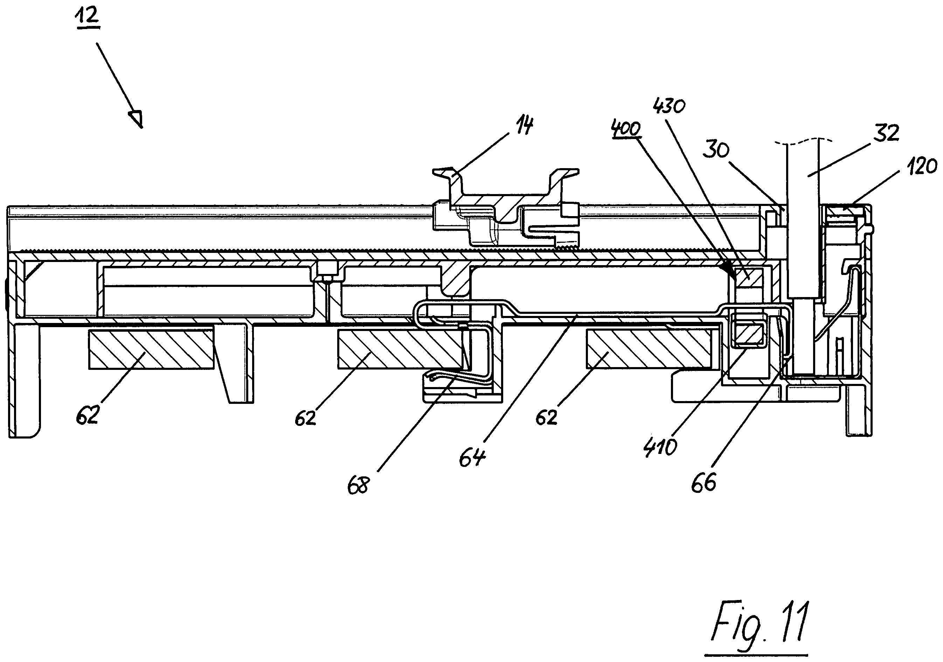

Fig. 11 zeigt schematisch einen Querschnitt durch den in Fig. 10 gezeigten Sammelschienenadapter 12, wobei in dieser Querschnittsansicht insbesondere gut die Befestigungsvorrichtungen 60 zur Befestigung des Sammelschienenadapters 12 an den Sammelschienen 62 sichtbar sind.

Der in Fig. 11 gezeigte Querschnitt zeigt eine Ebene des Sammelschienenadapters 12, in der ein Abgreifkontakt 68 für die mittlere Sammelschiene 62 verläuft.

Der Abgreifkontakt 68 ist einstückig mit einer Abgreifleitung 64 ausgebildet, die an eine Anschlussstelle 66 führt, die mit einer Anschlussleitung 32 in Verbindung steht, die in die Öffnung 30 des Sammelschienenadapters 12 eingeführt ist.

In Fig. 11 ist ebenfalls schematisch eine Spulenvorrichtung 400 mit einem Spulenkern 430 und einer ersten Spulenwicklung 410 gezeigt, die, wie in Zusammenhang mit den anderen Ausführungsformen beschrieben, mittels Induktion Energie für die Messvorrichtung liefert. Optional kann auch eine zweite Spulenwicklung 420 oder eine andere Vorrichtung vorgesehen sein, wie bspw. ein Shunt, mittels dem oder mittels denen elektrische Betriebswerte des Systems ermittelt werden, in diesem Falle der Phase, die mit der mittleren Stromschiene 62 in Verbindung steht.

Im Hinblick auf die Funktionsweise und die Vorteile einer solchen Ausführungsform wird insbesondere auf die vorhergehenden Beschreibungen verwiesen.

Die in der Beschreibung, den Ansprüchen und den Zeichnungen offenbarten Merkmale der Erfindung können sowohl einzeln als auch in beliebigen Kombinationen für die Verwirklichung wesentlich sein.

## Patentansprüche

1. Baugruppe für eine Schaltersicherungsanordnung (10), wobei die Baugruppe eine Messvorrichtung zur Ermittlung elektrischer Betriebswerte umfasst und wobei die Messvorrichtung eine Messelelctronik (300) und mindestens eine Anzeigevorrichtung (120) zur Anzeige mindestens eines der von der Messvorrichtung ermittelten elektrischen Betriebswerte aufweist, und wobei die Baugruppe mindestens eine Spulenvorrichtung (400) umfasst, die so ausgelegt ist, dass sie mittels Induktion Energie für die Messelektronik (300) und/oder die mindestens eine Anzeigevorrichtung (120) zur Verfügung stellen kann,
**dadurch gekennzeichnet, dass** sie mindestens einen Sicherungshalter (100) umfasst, wobei der mindestens eine Sicherungshalter (100) die Messelektronik (300), die mindestens eine Anzeigevorrichtung (120) und die mindestens eine Spulenvorrichtung (400) umfasst.

2. Baugruppe nach Anspruch 1, **dadurch gekennzeichnet, dass** die mindestens eine Spulenvorrichtung (400) einen Spulenkörper (430) und mindestens eine Spulenwicklung (410, 420) aufweist.

3. Baugruppe nach Anspruch 1 oder 2, **dadurch gekennzeichnet, dass** die Spulenvorrichtung (400) mindestens zwei Spulenwicklungen (410, 420) umfasst, wobei mindestens eine erste Spulenwicklung (410) so ausgelegt ist, dass sie Energie für die Messelektronik (300) und/oder die mindestens eine Anzeigevorrichtung (120) zur Verfügung stellt, wobei mindestens eine zweite Spulenwicklung (420) so mit der Messvorrichtung (300) verbunden ist, dass mittels der mindestens einen zweiten Spulenwicklung (420) und der Messelektronik (300) elektrische Betriebswerte ermittelt werden können.

4. Baugruppe nach einem der vorhergehenden Ansprüche, **dadurch gekennzeichnet, dass** die Messvorrichtung so ausgebildet ist, dass elektrische Betriebswerte für jede der Phasen der Baugruppe und/oder einer Schaltersicherungsanordnung (10) separat ermittelt werden können.

5. Baugruppe nach einem der vorhergehenden Ansprüche, **dadurch gekennzeichnet, dass** die Messvorrichtung für jede Phase eine eigene Messelektronik (300) umfasst.

6. Baugruppe nach einem der vorhergehenden Ansprüche, **dadurch gekennzeichnet, dass** die Messvorrichtung für jede Phase eine eigene Anzeigevorrichtung (120) umfasst.

7. Baugruppe nach einem der vorhergehenden Ansprüche, **dadurch gekennzeichnet, dass** sie mindestens eine Spulenvorrichtung (400) für jede Phase umfasst.

8. Baugruppe nach einem der vorhergehenden Ansprüche, **dadurch gekennzeichnet, dass** sie ein Gehäuse umfasst, wobei mindestens eine Messelektronik und/oder mindestens eine Anzeigevorrichtung (120) und/oder mindestens eine Spulenvorrichtung (400) in oder an dem Gehäuse angeordnet ist.

9. Baugruppe nach einem der vorhergehenden Ansprüche, **dadurch gekennzeichnet, dass** sie einen Akkumulator und/oder eine Batterie (660) und/oder eine Solarzelle (680) umfasst, der oder die so ausgelegt ist/sind, dass er/sie der Messvorrichtung Energie zuführen kann/können.

10. Baugruppe nach einem der vorhergehenden Ansprüche, **dadurch gekennzeichnet, dass** sie einen N-Leiter umfasst, der direkt oder indirekt an die Messvorrichtung (300) angeschlossen ist.

11. Baugruppe nach einem der vorhergehenden Ansprüche, wobei die Baugruppe eine Schaltersicherungsanordnung, insbesondere für Sammelschienensysteme, oder ein Einbaugerät ist, die eine oder mehrere Schaltersicherungseinheiten zur Aufnahme je eines Sicherungshalters (100) umfasst, der so ausgebildet ist, dass er einen Sicherungseinsatz aufnehmen kann.

12. Sicherungshalter (100) für eine Baugruppe einer Schaltersicherungsanordnung oder für eine Schaltersicherungsanordnung (10), der so ausgebildet ist, dass er einen Sicherungseinsatz (200) aufnehmen kann, und der eine Messvorrichtung zur Ermittlung elektrischer Betriebswerte umfasst, wobei die Messvorrichtung eine Messelektronik (300) und mindestens eine Anzeigevorrichtung (120) zur Anzeige mindestens eines der von der Messvorrichtung ermittelten elektrischen Betriebswerte aufweist, und wobei der Sicherungshalter (100) mindestens eine Spulenvorrichtung (400) umfasst, die so ausgelegt ist, dass sie mittels Induktion Energie für die Messelektronik (300) und/oder die mindestens eine Anzeigevorrichtung (120) zur Verfügung stellen kann.

13. Sicherungshalter nach Anspruch 12, **dadurch gekennzeichnet, dass** die mindestens eine Spulenvorrichtung (400) einen Spulenkörper (430) und mindestens eine Spulenwicklung aufweist.

14. Sicherungshalter nach Anspruch 12 oder 13, **dadurch gekennzeichnet, dass** die Spulenvorrichtung (400) mindestens zwei Spulenwicklungen (410, 420) umfasst, wobei mindestens eine erste Spulenwicklung (410) so ausgelegt ist, dass sie Energie für die Messelektronik (300) und/oder die mindestens eine Anzeigevorrichtung (120) zur Verfügung stellt, wobei mindestens eine zweite Spulenwicklung so mit der Messvorrichtung (300) verbunden ist, dass mittels der mindestens einen zweiten Spulenwicklung (420) und der Messelektronik (300) elektrische Betriebswerte ermittelt werden können.

15. Sicherungshalter nach einem der Ansprüche 12 bis 14, **dadurch gekennzeichnet, dass** er einen Akkumulator und/oder eine Batterie (660) und/oder eine Solarzelle (680) umfasst, der oder die so ausgelegt ist/sind, dass er/sie der Messvorrichtung (300) Energie zuführen kann/können.

## Claims

1. A subassembly for a switch fuse arrangement (10), wherein the subassembly comprises a measuring device for determining electrical operational values and wherein the measuring device comprises measuring electronics (300) and at least one display device (120) for displaying at least one of the electrical operational values determined by the measuring device, and wherein the subassembly comprises at least one coil device (400), which is constituted such that it can make energy available by means of induction for the measuring electronics (300) and/or the at least one display device (120),
**characterised in that** it comprises at least one fuse holder (100), wherein the at least one fuse holder (100) comprises the measuring electronics (300), the at least one display device (120) and the at least one coil device (400).

2. The subassembly according to claim 1, **characterised in that** the at least one coil device (400) comprises a coil body (430) and at least one coil winding (410, 420).

3. The subassembly according to claim 1 or 2, **characterised in that** the coil device (400) comprises at least two coil windings (410, 420), wherein at least a first coil winding (410) is constituted such that it makes energy available for the measuring electronics (300) and/or the at least one display device (120), wherein at least one second coil winding (420) is connected to the measuring device (300) in such a way that electrical operational values can be determined by means of the at least one second coil winding (420) and the measuring electronics (300).

4. The subassembly according to any one of the preceding claims, **characterised in that** the measuring device is constituted such that the electrical operational values can be determined separately for each of the phases of the subassembly and/or of a switch fuse arrangement (10).

5. The subassembly according to any one of the preceding claims, **characterised in that** the measuring device comprises separate measuring electronics (300) for each phase.

6. The subassembly according to any one of the preceding claims, **characterised in that** the measuring device comprises a separate display device (120) for each phase.

7. The subassembly according to any one of the preceding claims, **characterised in that** it comprises at least one coil device (400) for each phase.

8. The subassembly according to any one of the preceding claims, **characterised in that** it comprises a housing, wherein at least one measuring electronics and/or at least one display device (120) and/or at least one coil device (400) is arranged in or on the housing.

9. The subassembly according to any one of the preceding claims, **characterised in that** it comprises an accumulator and/or a battery (660) and/or a solar cell (680), which is/are constituted such that it/they can supply energy to the measuring device.

10. The subassembly according to any one of the preceding claims, **characterised in that** it comprises an N-conductor, which is connected directly or indirectly to the measuring device (300).

11. The subassembly according to any one of the preceding claims, wherein the subassembly is a switch fuse arrangement, in particular for busbar systems, or an installation device, which comprises one or more switch fuse units for receiving in each case a fuse holder (100), which is constituted such that it can receive a fuse link.

12. A fuse holder (100) for a subassembly of a switch fuse arrangement or for a switch fuse arrangement (10) which is constituted such that it can receive a fuse link (200), and which comprises a measuring device for determining electrical operational values, wherein the measuring device comprises measuring electronics (300) and at least one display device (120) for displaying at least one of the electrical operational values determined by the measuring device, and wherein the fuse holder (100) comprises at least one coil device (400), which is constituted such that it can make energy available by means of induction for the measuring electronics (300) and/or the at least one display device (120).

13. The fuse holder according to claim 12, **characterised in that** the at least one coil device (400) comprises a coil body (430) and at least one coil winding.

14. The fuse holder according to claim 12 or 13, **characterised in that** the coil device (400) comprises at least two coil windings (410, 420), wherein at least a first coil winding (410) is constituted such that it can make energy available for the measuring electronics (300) and/or the at least one display device (120), wherein at least one second coil winding is connected to the measuring device (300) in such a way that electrical operational values can be determined by means of the at least one second coil winding (420) and the measuring electronics (300).

15. The fuse holder according to any one of claims 12 to 14, **characterised in that** it comprises an accumulator and/or a battery (660) and/or a solar cell (680), which is/are constituted such that it/they can supply energy to the measuring device (300).

## Revendications

1. Sous-ensemble pour un dispositif de protection par interrupteur (10), le sous-ensemble comprenant un dispositif de mesure pour la détermination de valeurs de fonctionnement électriques et le dispositif de mesure comprenant une électronique de mesure (300) et au moins un dispositif d'affichage (120) pour l'affichage d'au moins une des valeurs de fonctionnement électriques déterminées par le dispositif de mesure, et le sous-ensemble comprenant au moins un dispositif à bobine (400), qui est conçu de façon à fournir, par induction, de l'énergie à l'électronique de mesure (300) et/ou à l'au moins un dispositif d'affichage (120), **caractérisé en ce qu'**il comprend au moins un support de fusible (100), l'au moins un support de protection (100) comprenant l'électronique de mesure (300), qui comprend l'au moins un dispositif d'affichage (120) et l'au moins un dispositif à bobine (400).

2. Sous-ensemble selon la revendication 1, **caractérisé en ce que** l'au moins un dispositif à bobine (400) comprend un corps à bobine (430) et au moins un enroulement de bobine (410, 420).

3. Sous-ensemble selon la revendication 1 ou 2, **caractérisé en ce que** le dispositif à bobine (400) comprend au moins deux enroulements de bobine (410, 420), au moins un premier dispositif à bobine (410) étant conçu de façon à fournir de l'énergie à l'électronique de mesure (300) et/ou à l'au moins un dispositif d'affichage (120), au moins un deuxième enroulement de bobine (420) étant relié avec le dispositif de mesure (300) de façon à ce que des valeurs de fonctionnement électriques puissent être déterminées au moyen de l'au moins un deuxième enroulement de bobine (420) et de l'électronique de mesure (300).

4. Sous-ensemble selon l'une des revendications précédentes, **caractérisé en ce que** le dispositif de mesure est conçu de façon à ce que des valeurs de fonctionnement électriques puissent être déterminées séparément pour chacune des phases du sous-ensemble et/ou d'un dispositif de protection par interrupteur (10).

5. Sous-ensemble selon l'une des revendications précédentes, **caractérisé en ce que** le dispositif de mesure comprend une électronique de mesure (300) distincte pour chaque phase.

6. Sous-ensemble selon l'une des revendications précédentes, **caractérisé en ce que** le dispositif de mesure comprend un dispositif d'affichage (120) distinct pour chaque phase.

7. Sous-ensemble selon l'une des revendications précédentes, **caractérisé en ce qu'**il comprend un dispositif à bobine (400) pour chaque phase.

8. Sous-ensemble selon l'une des revendications précédentes, **caractérisé en ce qu'**il comprend un boîtier, au moins une électronique de mesure et/ou au moins un dispositif d'affichage (120) et/ou au moins un dispositif à bobine (400) étant disposé dans ou sur le boîtier.

9. Sous-ensemble selon l'une des revendications précédentes, **caractérisé en ce qu'**il comprend un accumulateur et/ou une batterie (660) et/ou une cellule photovoltaïque (680), qui est/sont conçu(es) de façon à pouvoir fournir de l'énergie au dispositif de mesure.

10. Sous-ensemble selon l'une des revendications précédentes, **caractérisé en ce qu'**il comprend un conducteur N, qui est branché directement ou indirectement au dispositif de mesure (300).

11. Sous-ensemble selon l'une des revendications précédentes, le sous-ensemble étant un dispositif de protection par interrupteur, plus particulièrement pour des systèmes à rails collecteurs, ou un appareil encastré, qui comprend une ou plusieurs unités de protection par interrupteur pour le logement d'un support de protection (100), qui est conçu de façon à pouvoir loger un insert de protection.

12. Support de protection (100) pour un sous-ensemble d'un dispositif de protection par interrupteur ou pour un dispositif de protection par interrupteur (10), qui est conçu de façon à pouvoir loger un insert de protection (200) et qui comprend un dispositif de mesure pour la détermination de valeurs de fonctionnement électriques, le dispositif de mesure comprenant une électronique de mesure (300) et au moins un dispositif d'affichage (120) pour l'affichage d'au moins une des valeurs de fonctionnement électriques déterminées par le dispositif de mesure et le support de protection (100) comprenant au moins un dispositif à bobine (400), qui est conçu de façon à pouvoir fournir, par induction, de l'énergie à l'électronique de mesure (300) et/ou à l'au moins un dispositif d'affichage (120).

13. Support de protection selon la revendication 12, **caractérisé en ce que** l'au moins un dispositif à bobine (400) comprend un corps à bobine (430) et au moins un dispositif à bobine.

14. Support de protection selon la revendication 12 ou 13, **caractérisé en ce que** le dispositif à bobine (400) comprend au moins deux enroulements de bobine (410, 420), au moins un premier enroulement de bobine (410) étant conçu fournir de l'énergie à l'électronique de mesure (300) et/ou à l'au moins un dispositif d'affichage (120), au moins un deuxième enroulement de bobine étant relié avec le dispositif de mesure (300) de façon à pouvoir déterminer des valeurs de fonctionnement électriques au moyen de l'au moins un deuxième enroulement de bobine (420) et de l'électronique de mesure (300).

15. Support de protection selon l'une des revendications 12 à 14, **caractérisé en ce qu'**il comprend un accumulateur et/ou une batterie (660) et/ou une cellule photovoltaïque (680), qui est/sont conçu(es) de façon à pouvoir fournir de l'énergie au dispositif de mesure (300).
